Europäisches Patentamt

European Patent Office

Office européen des brevets

(19)

(11) **EP 1 542 415 A2**

(12) ## EUROPEAN PATENT APPLICATION

(43) Date of publication:
**15.06.2005 Bulletin 2005/24**

(51) Int Cl.⁷: **H04L 25/03**

(21) Application number: **04027557.0**

(22) Date of filing: **19.11.2004**

| | |
|---|---|
| (84) Designated Contracting States:<br>**AT BE BG CH CY CZ DE DK EE ES FI FR GB GR HU IE IS IT LI LU MC NL PL PT RO SE SI SK TR**<br>Designated Extension States:<br>**AL HR LT LV MK YU**<br><br>(30) Priority: **03.12.2003 JP 2003405022**<br><br>(71) Applicant: **Pioneer Corporation**<br>**Meguro-ku, Tokyo (JP)** | (72) Inventors:<br>• **Yamamoto, Yuji, c/o Kawagoe Koujou**<br>  **Kawagoe-shi, Saitama-ken 350-8555 (JP)**<br>• **Kubuki, Toshiaki, c/o Kawagoe Koujou**<br>  **Kawagoe-shi, Saitama-ken 350-8555 (JP)**<br><br>(74) Representative: **Popp, Eugen, Dr. et al**<br>**MEISSNER, BOLTE & PARTNER**<br>**Postfach 86 06 24**<br>**81633 München (DE)** |

(54) **Transversal equaliser**

(57)    A digital filter (2) comprising delay elements ($D_0$ - $D_{m-1}$), multipliers ($MP_0$ - $MP_m$), and an adder (ADD), receives a digitized FM or phase modulated signal as its input ($Xin(t)$), and generates an output signal ($Y(t)$). A unit (3) detects and smooths the envelope of the input signal ($Xin(t)$) to generate a direct-current reference signal ($Vth(t)$) as an evaluation criterion. An error detecting unit (4) calculates an error signal ($e(t)$) which is the difference between the reference signal ($Vth(t)$) and the desired signal ($Y(t)$). An error component limiting unit (5) determines and smooths the absolute value of the error signal ($e(t)$) to generate a direct-current error signal, and monitors whether the direct-current error signal exceeds a predetermined value or not. If the predetermined value is exceeded, the error component limiting unit (5) outputs a corrected error signal ($e_{cp}(t)$) which is generated by suppressing the amplitude of the error signal ($e(t)$). The filter adjusts the tap weights ($K_0$ - $K_m$) of the multipliers ($MP_0$ - $MP_m$) so that the amplitudes of the error signal ($e(t)$) and the corrected error signal ($e_{cp}(t)$) approach zero. This makes the entire system converge, thereby generating a signal ($Y(t)$) from which multipath distortion is eliminated.

*FIG.1*

EP 1 542 415 A2

**Description**

BACKGROUND OF THE INVENTION

The present invention relates to a multipath elimination filter, and more particularly to a multipath elimination filter for eliminating multipath distortion which occurs during the reception of an FM modulation signal or a phase modulation signal.

For example, in the field of mobile communication, what is problematic when receivers receive and demodulate FM modulation signals or phase modulation signals is poor reception which occurs from multiple propagation of the radio waves, i.e., multipath distortion.

Examples of this multipath distortion include ones ascribable to the superposition of reflected-wave components from buildings on desired direct-wave components in urban areas, and ones ascribable to the superposition of reflected-wave components from mountains on desired direct-wave components. Since it deteriorates the reception quality, the multipath distortion is a problem of extreme significance.

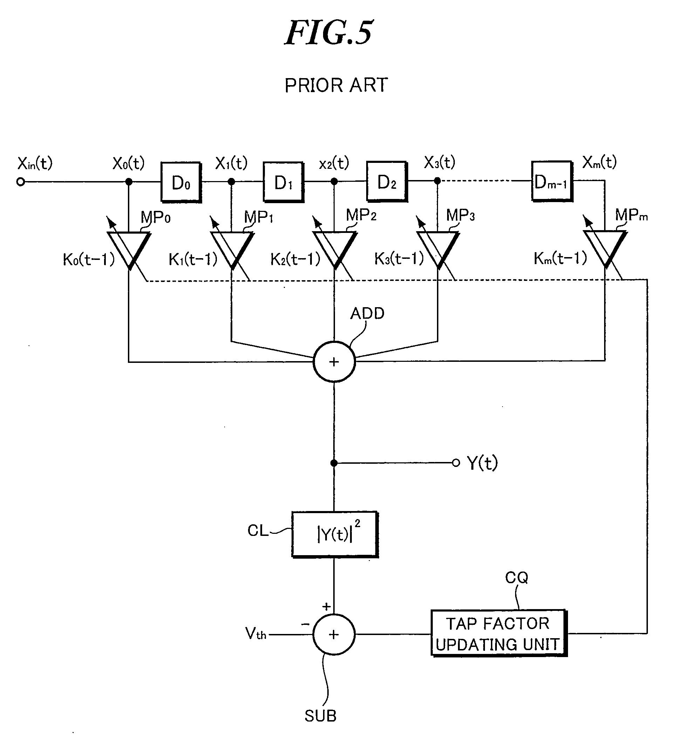

For receivers intended to receive FM broadcasts, there has thus been proposed a multipath elimination filter which utilizes a digital filter as shown in Fig. 5, for the sake of eliminating this multipath distortion.

In Fig. 5, this multipath elimination filter is formed through the use of an FIR digital filter. A digital signal Xin (t) which is generated by an A/D converter performing analog-to-digital conversion on an intermediate frequency signal is input to the FIR digital filter.

Then, the digital signal Xin(t) is delayed by m stages of delay elements $D_0$ to $D_{m-1}$, each having a delay time T which is equal to the reciprocal of the sampling frequency. In the meantime, (m + 1) multipliers $MP_0$ to $MP_m$ (the number of taps of m + 1) multiply the most recent digital signal $X_0(t)$ and the digital signals $X_1(t)$ to $X_m(t)$ output from the respective delay elements $D_0$ to $D_{m-1}$ by tap factors $K_0(t)$ to $K_m(t)$. Moreover, an adder ADD adds the (m + 1) outputs of the multipliers $MP_0$ to $MP_m$ to obtain a desired signal Y(t) from which multipath distortion is eliminated. The desired signal Y(t) is output to a demodulator and the like.

Besides, a calculator CL determines the square of the absolute value of the desired signal Y(t). A subtractor SUB subtracts a predetermined fixed reference value Vth from the squared absolute value $|Y(t)|^2$ to obtain an error component e(t). Furthermore, a tap factor updating unit CQ adjusts the tap factors $K_0(t)$ to $K_m(t)$ of the respective multipliers $MP_0$ to $MP_m$ so that the error component e (t) converges to near zero. The multiple distortion varying with time is eliminated in this way.

As above, the conventional multipath elimination filter approximates the inverse characteristic of the multipath propagation channel by using the FIR digital filter of Fig. 5. To eliminate the varying multipath distortion, it also adjusts the individual tap factors $K_0(t)$ to $K_m(t)$ in synchronization with the foregoing delay time T by using the calculator CL, the subtractor SUB, and the tap factor updating unit CQ so that the error component e(t) converges to near zero, based on a tap factor updating algorithm expressed by the following equation (1):

$$K_j(t) = K_j(t-1) - \alpha \cdot e(t) \cdot \{X_j(t) \cdot Y(t) + X_j(t-1) \cdot Y(t-1)\} \qquad \text{[Eq. 1]}$$

where: j = 0, 1, 2, 3, ... m; $\alpha$ > 0; and t is a natural number indicating the point of time in units of delay time T.

Now, the conventional multipath elimination filter has had the problem that the effect of eliminating multipath distortion tends to depend on the characteristic of the reflected-wave components, or in other words, the actual characteristic of the multipath propagation channel.

For example, in urban areas and the like, reflected-wave components reflected from buildings have propagation delay times of 10 μs (micro seconds) to 20 μs or so with respect to direct-wave components. In mountainous areas and the like, on the other hand, the propagation delay times sometimes exceed 50 μs. If such reflected-wave components as exceed 50 μs in propagation delay time are superimposed on direct-wave components to cause multipath distortion, the multipath components of the digital signal Xin(t) might have delay times longer than the total delay time (m × T) of the multipath elimination filter, which is determined by the delay elements D0 to Dm-1 arranged inside. In such cases, it is difficult to make the error component e(t) converge to near zero even if the individual tap factors $K_0(t)$ to $K_m(t)$ are adjusted based on the foregoing tap factor updating algorithm. Then, the convergence failure may later make the multipath elimination filter unstable in operation.

SUMMARY OF THE INVENTION

It is an object of the present invention to provide a multipath distortion elimination filter which is less susceptible to such a characteristic of the multipath propagation channel, can avoid instability, and can eliminate multipath distortion appropriately.

A multipath elimination filter according to a first aspect of the present invention comprises: a digital filter for receiving a digitalized FM modulation signal or phase modulation signal as its input signal, and eliminating multipath distortion from the input signal by adjusting tap factors for the input signal; envelope detecting means for detecting an envelope of the input signal to generate a reference signal; error detecting means for generating an error signal by performing a differential operation on a desired signal generated by the digital filter and the reference signal; error component limiting means for monitoring the error signal for a direct-current component and controlling the amplitude of the error signal to generate a corrected error signal; and tap factor updating means for adjusting the tap factors based on the corrected error signal so that the amplitude of the error signal approaches zero.

According to a second aspect of the invention, in the multipath elimination filter according to the first aspect, the tap factor updating means adjusts the individual tap factors according to an algorithm expressed by

$$K_j(t) = K_j(t-1) - \alpha \cdot e_{cp}(t) \cdot \{X_j(t) \cdot Y(t) + X_j(t-1) \cdot Y(t-1)\},$$

where $X_j(t)$ and $X_j(t-1)$ are the input signal, $Y(t)$ and $Y(t-1)$ are the desired signal, $K_j(t)$ and $K_j(t-1)$ are the tap factors, $\alpha$ is a predetermined constant, t is a delay time determined based on a sampling frequency, j is the order of the tap factors, and $e_{cp}(t)$ is the corrected error signal.

According to a third aspect of the invention, in the multipath elimination filter according to the first or second aspect, the tap factor updating means adjusts the individual tap factors according to an algorithm expressed by

$$K_j(t) = \gamma \cdot K_j(t-1) - \alpha \cdot e_{cp}(t) \cdot \{X_j(t) \cdot Y(t) + X_j(t-1) \cdot Y(t-1)\},$$

where $X_j(t)$ and $X_j(t-1)$ are the input signal, $Y(t)$ and $Y(t-1)$ are the desired signal, $K_j(t)$ and $K_j(t-1)$ are the tap factors, $\alpha$ is a predetermined constant, t is a delay time determined based on a sampling frequency, j is the order of the tap factors, $e_{cp}(t)$ is the corrected error signal, and $\gamma$ is any predetermined constant in the range of 0 and 1.

BRIEF DESCRIPTION OF THE DRAWINGS

These and other obj ects and advantages of the present invention will become clear from the following description with reference to the accompanying drawings, wherein:

Fig. 1 is a block diagram showing the configuration of a multipath elimination filter according to an embodiment;
Fig. 2 is a block diagram showing the configuration of a multipath elimination filter according to a practical example;
Fig. 3 is a waveform chart for explaining the characteristic of the multipath filter shown in Fig. 2;
Fig. 4 is a waveform chart showing the characteristic of a conventional multipath elimination filter for the sake of comparison and verification with the multipath elimination filter shown in Fig. 2; and
Fig. 5 is a block diagram showing the configuration of the conventional multipath elimination filter.

DETAILED DESCRIPTION OF THE PREFERRED EMBODIMENTS

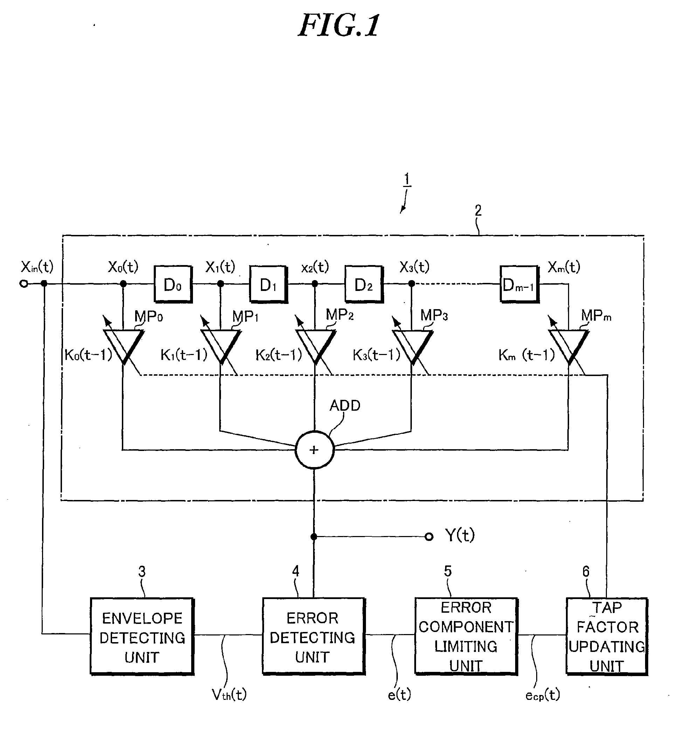

Hereinafter, description will be given of a preferred embodiment of the present invention, or a multipath elimination filter to be incorporated in a radio receiver for receiving FM broadcasts and the like. Fig. 1 is a block diagram showing the configuration of the multipath elimination filter according to the present embodiment.

In Fig. 1, the multipath elimination filter 1 comprises a digital filter 2, an envelope detecting unit 3, an error detecting unit 4, an error component limiting unit 5, and a tap factor updating unit 6.

This multipath elimination filter 1 receives, as its input signal Xin(t), a series of digital signals which are generated by converting a reception signal of radio frequency received at a reception antenna into an FM modulation signal or phase modulation signal of intermediate frequency, followed by analog-to-digital conversion in an A/D converter. The multipath elimination filter 1 generates a desired signal Y (t) from which multipath distortion is eliminated, and outputs the same to a demodulation circuit and the like.

The digital filter 2 is made of an FIR digital filter which is approximated to the inverse characteristic of the multipath propagation channel through Taylor expansion and is capable of changing tap factors. The digital filter 2 eliminates multipath distortion from the input signal Xin(t) to generate the desired signal (in other words, predicated signal) Y(t) for output.

More specifically, for example, the sampling frequency fs is determined to be four times the frequency of the carrier. The input signal Xin(t) is delayed by m stages of delay elements $D_0$ to $D_{m-1}$, each having a delay time T which is equal to the reciprocal of the sampling frequency fs. In the meantime, (m + 1) multipliers $MP_0$ to $MP_m$ (the number of taps of m + 1) multiply the most recent input signal $X_0(t)$ and the digital signals $X_1(t)$ to $X_m(t)$ output from the respective delay elements $D_0$ to $D_{m-1}$ by tap factors $K_0(t)$ to $K_m(t)$. Then, an adder ADD adds the (m + 1) outputs of the multipliers $MP_0$ to $MP_m$ to generate and output the desired signal Y(t) from which multipath distortion is eliminated.

The envelope detecting unit 3 detects the envelope component of the multipath-affected input signal Xin(t), and smoothens the detected envelope component to obtain the variation of the envelope component as a direct-current reference signal Vth(t).

The error detecting unit 4 calculates the difference between the desired signal Y(t) output from the digital filter 2 and the reference signal Vth(t), as an error component e(t).

The error component limiting unit 5 smoothens the error component e(t) to generate a direct-current error component. If the direct-current error component exceeds a predetermined value, the error component limiting unit 5 generates and outputs a signal into which the error component e (t) is suppressed, i.e., a corrected error component $e_{cp}(t)$.

The tap factor updating unit 6 adjusts the individual tap factors $K_0(t)$ to $K_m(t)$ of the digital filter 2 adaptively so that the corrected error component $e_{cp}$ converges to near zero, based on a tap factor updating algorithm expressed by the following equation (2a) :

$$K_j(t) = K_j(t-1) - \alpha \cdot e_{cp}(t) \cdot \{X_j(t) \cdot Y(t) + X_j(t-1) \cdot Y(t-1)\} \qquad \text{[Eq. 2a]}$$

where: j = 0, 1, 2, 3, ... m; $\alpha > 0$; and t is a natural number indicating the point of time in units of delay time T.

According to the multipath elimination filter 1 having such a configuration, the tap factors $K_0(t)$ to $K_m(t)$ of the multipliers $MP_0$ to $MP_m$ can be adjusted based on the tap factor updating algorithm of the foregoing equation (2a), whereby the digital filter 2 is operated as an adaptive digital filter capable of automatically following the input signal Xin(t) undergoing actual multipath effects. It is therefore possible to generate a desired signal Y (t) of high quality from which multipath distortion is eliminated.

In other words, the tap factor updating unit 6 adjusts the tap factors $K_0(t)$ to $K_m(t)$ of the multipliers $MP_0$ to $MP_m$ based on the foregoing equation (2a) by utilizing the corrected error signal $e_{cp}(t)$ which is generated from the error component e(t), the difference between the direct-current reference voltage Vth(t) generated by the envelope detecting unit 3 and the desired signal Y(t) output from the digital filter 2. This allows the digital filter 2 to generate the desired signal Y(t) having a constant envelope conforming to the characteristic that FM modulation signals or phase modulation signals originally have constant envelopes.

It is therefore possible to generate a desired signal Y(t) of high quality from which multipath distortion is eliminated.

Moreover, in cases where the foregoing error component e (t) makes no convergence toward zero because of actual multipath effects, the tap factor updating unit 6 adjusts the tap factors $K_0(t)$ to $K_m(t)$ based on the tap factor updating algorithm of the foregoing equation (2a), by utilizing the corrected error component $e_{cp}(t)$ which is generated by the error component limiting unit 5 through the suppression of the value (i.e., amplitude) of the error component e (t). Consequently, variations of the individual tap factors $K_0(t)$ to $K_m(t)$ are suppressed to inhibit the adaptive operation of the digital filter 2.

Consequently, the multipath elimination filter 1 of the present embodiment can suppress the variations of the individual tap factors $K_0(t)$ to $K_m(t)$ for stable operation even in situations where the operation of the multipath elimination filter might become unstable due to the actual characteristic of the multipath propagation channel. Examples of the situations include the case illustrated as the conventional problem, in which the delay time of the multipath component exceeds the total delay time (m $\times$ T) determined by the delay elements $D_0$ to $D_{m-1}$ in the digital filter 2 having the number of taps of m + 1.

The tap factor updating unit 6 may also control the individual tap factors $K_0(t)$ to $K_m(t)$ according to the algorithm expressed by the following equation (2b). According to this algorithm, the operation of the multipath elimination filter can be stabilized more effectively.

$$K_j(t) = \gamma \cdot K_j(t-1) - \alpha \cdot e_{cp}(t) \cdot \{X_j(t) \cdot Y(t) + X_j(t-1) \cdot Y(t-1)\} \qquad \text{[Eq. 2b]}$$

where: j is the order of the tap factors, j = 0, 1, 2, 3, ... m;
$\alpha$ and $\gamma$ are predetermined constants, $\alpha > 0$ and $0 < \gamma < 1$;
t is a natural number indicating the point of time in units of delay time T; and
$e_{cp}(t)$ is the corrected error signal.

[Practical Example]

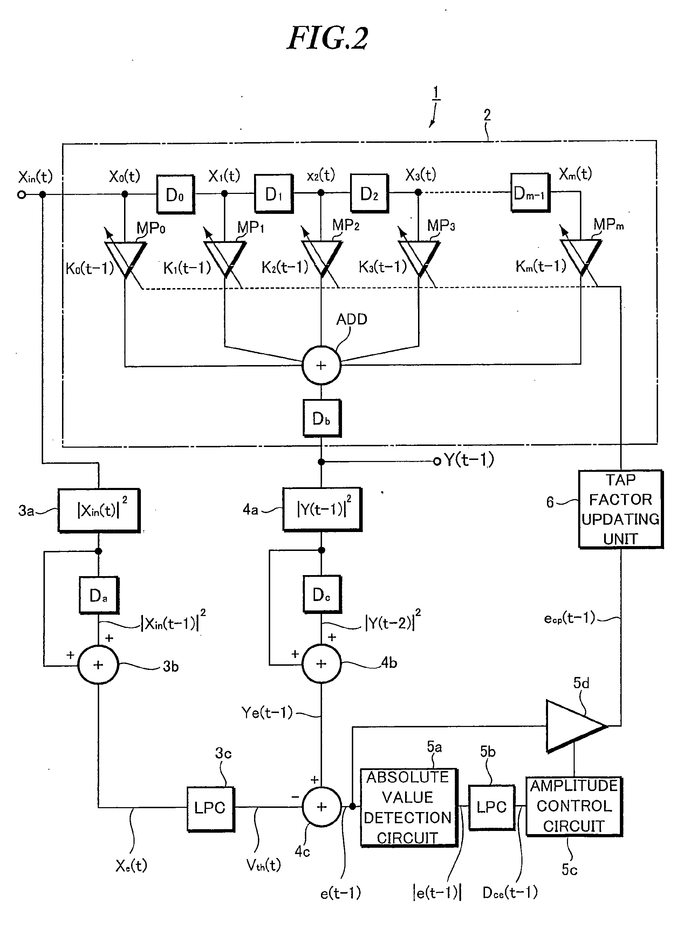

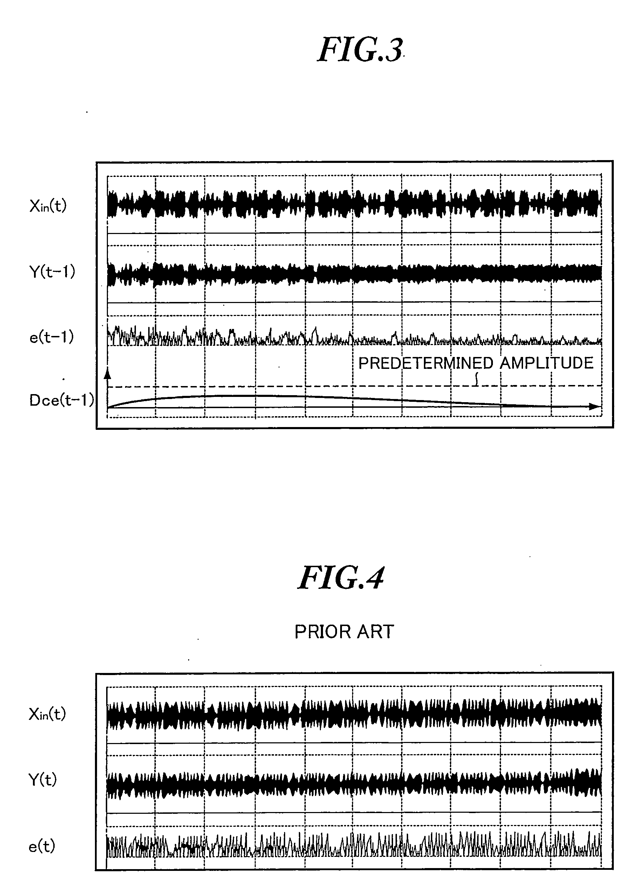

Next, with reference to Figs. 2-4, description will be given of a more specific practical example. Fig. 2 is a block diagram showing the configuration of the multipath elimination filter of this practical example. Figs. 3 and 4 are waveform charts for explaining the characteristic of this multipath elimination filter.

In Fig. 2, parts identical or equivalent to those of Fig. 1 are designated by the same reference numerals.

In Fig. 2, this multipath elimination filter 1 comprises the same digital filter 2 as that shown in Fig. 1. Note that the output of the adder AD of the digital filter 2 is connected with a delay element Db which is given a delay time T. The output of this delay element Db is output as the desired signal Y(t-1).

The circuit equivalent to the envelope detecting unit 3 of Fig. 1 comprises a calculator 3a, a delay element Da having a delay time T, an adder 3b, and a digital low-pass filter 3c.

The calculator 3a calculates the square of the absolute value of the input signal Xin(t), or $|Xin(t)|^2$. The delay element Da delays the squared absolute value $|Xin(t)|^2$ by the delay time T, and outputs the squared absolute value before the delay time T, or $|Xin(t-1)|^2$.

The adder 3b adds the foregoing values $|Xin(t)|^2$ and $|Xin(t-1)|^2$ to output an envelope signal Xe(t) which shows the envelope of the input signal Xin(t).

The digital low-pass filter 3c smoothens the envelope signal Xe(t) into a direct-current reference signal Vth(t) for output.

The circuit equivalent to the error detecting unit 4 of Fig. 1 comprises a calculator 4a, a delay element Dc having a delay time T, an adder 4b, and a subtractor 4c.

The calculator 4a calculates the square of the absolute value of the desired signal Yin(t-1), or $|Yin(t-1)|^2$. The delay element Dc delays the squared absolute value $|Yin(t-1)|^2$ by the delay time T, and outputs the squared absolute value before the delay time T, or $|Yin(t-2)|^2$.

The adder 4b adds the foregoing values $|Y(t-1)|^2$ and $|Y(t-2)|^2$ to output an envelope signal Ye(t-1) which shows the envelope remaining as an error in the desired signal Y(t-1).

The subtractor 4c subtracts the reference signal Vth(t) from the envelope signal Ye(t-1), thereby outputting an error signal e(t-1) which shows the difference therebetween. That is, as described above, the reference signal Vth(t) is generated by smoothening the envelope signal Xe(t) which shows the envelope of the input signal Xin(t). The reference signal Vth(t) thus makes a so-called evaluation criterion for adjusting the tap factors $K_0(t)$ to $K_m(t)$ of the digital filter 2 adaptively by utilizing the constant-amplitude characteristic of FM modulation signals or phase modulation signals. Then, the subtractor 4c subtracts the reference signal Vth(t), or evaluation criterion, from the envelope signal Ye(t-1) to generate the error signal e(t-1) for adjusting the tap factors $K_0(t)$ to $K_m(t)$ of the digital filter 2 adaptively.

Now, the circuit equivalent to the error component limiting unit 5 of Fig. 1 comprises an absolute value detection circuit 5a, a digital low-pass filter 5b, an amplitude control circuit 5c, and an amplitude limiting circuit 5d which is made of a digital attenuator or an amplifier circuit.

The absolute value detection circuit 5a determines the absolute value of the error signal e(t-1) to output an absolute value signal $|e(t-1)|$. The digital low-pass filter 5c smoothens the foregoing absolute value signal $|e(t-1)|$ to output a smoothened error signal Dce(t-1).

The amplifier control circuit 5c monitors the amplitude of the error signal Dce(t-1) successively. When the amplitude of the error signal Dce(t-1) exceeds a predetermined value, the amplitude control circuit 5c controls the amplitude limiting circuit 5d to adjust its attenuation or gain, thereby suppressing the amplitude of the error signal e (t-1) and outputting the amplitude-suppressed, corrected error signal $e_{cp}(t-1)$.

More specifically, the amplitude limiting circuit 5d, as described above, is made of a digital attenuator or an amplifier circuit.

If the amplitude limiting circuit 5d is made of a digital attenuator, it changes the attenuation under the control of the amplitude control circuit 5c, whereby the amplitude of the error signal e(t-1) input thereto is suppressed to output the amplitude-suppressed, corrected error signal $e_{cp}(t-1)$.

If the amplitude limiting circuit 5d is made of an amplifier, it changes the gain under the control of the amplitude control circuit 5c, whereby the amplitude of the error signal e(t-1) input thereto is suppressed to output the amplitude-suppressed, corrected error signal $e_{cp}(t-1)$ .

In this practical example, the amplitude control circuit 5c determines the logarithm of the value of the error signal Dce(t-1). Based on a value proportional to the logarithmic value, the amplitude limiting circuit 5d increases its attenuation or decreases its gain to suppress the amplitude of the error signal e(t-1), thereby outputting the amplitude-suppressed, corrected error signal $e_{cp}(t-1)$.

The tap factor updating unit 6 adjusts the individual tap factors $K_0(t)$ to $K_m(t)$ of the digital filter 2 adaptively based on the tap factor updating algorithm expressed by the foregoing equation (2a) so that the corrected error component $e_{cp}(t-1)$ converges to near zero.

When the multipath elimination filter of this practical example having such a configuration receives an input signal Xin(t), it conducts processing in synchronization with the delay time T described above. Then, the digital filter 2 delays the input signal Xin(t) in steps of the delay time T by using the m stages of delay elements $D_0$ to $D_{m-1}$ while the resultants are multiplied by the tap factors $K_0(t-1)$ to $K_m(t-1)$ of the multipliers $MP_0$ to $MP_m$. Moreover, the adder ADD adds the (m + 1) outputs of the multipliers $MP_0$ to $MP_m$ to generate the desired signal Y(t) before the delay element Dc delays the desired signal Y(t) by time T to output the desired signal Y(t-1).

Here, since the delay element Db has the delay time T, it is possible to separate the processing of the digital filter 2 and that of the subsequent circuits including the calculator 4a temporally, with a reduced load on the digital filter 2.

Furthermore, the calculator 3a, the delay element Da, the adder 3b, and the digital low-pass filter 3c described above generate the reference signal Vth(t), the evaluation criterion, while the calculator 4a, the delay element Dc, the adder 4b, and the subtractor 4c calculate the error signal e(t-1). Subsequently, the error signal e(t-1) is processed by the absolute value detection circuit 5a, the digital low-pass filter 5b, the amplitude control circuit 5c, and the amplitude limiting circuit 5d, whereby the amplitude-suppressed error signal e(t-1) is generates as the corrected error signal $e_{cp}$(t-1).

Then, the tap factor updating unit 6 adjusts the individual tap factors $K_0(t)$ to $K_m(t)$ of the digital filter 2 adaptively based on the tap factor updating algorithm expressed by the foregoing equation (2a) so that the corrected error component $e_{cp}$(t-1) converges to near zero.

As above, according to the multipath elimination filter 1 of this practical example, when the amplitude of the error signal e(t-1) exceeds the predetermined value, the tap factors $K_0(t)$ to $K_m(t)$ are adjusted as shown by the foregoing equation (2a) based on the amplitude-suppressed error signal e(t-1), or the corrected error signal $e_{cp}$(t-1). This can suppress variations of the tap factors $K_0(t)$ to $K_m(t)$ and stabilize the digital filter 2. The stabilization of the digital filter 2 then makes it possible to achieve the multipath elimination filter 1 which is free from instability ascribable to the characteristic of the multipath propagation channel.

To be more specific, when the tap factor updating unit 6 adjusts the tap factors $K_0(t)$ to $K_m(t)$ according to the algorithm expressed by the foregoing equation (2a) , the time necessary for the foregoing convergence is determined depending on the predetermined coefficient $\alpha$.

Here, the error signal e(t-1) output from the subtractor 4c is input to the digital low-pass filter 5b through the absolute value detecting circuit 5a. The error signal Dce(t-1) is thus settled gradually according to the time constant characteristic of the digital low-pass filter 5b.

That is, in the period before the settled error signal Dce(t-1) is supplied to the amplitude control circuit 5c, the digital filter 2 is capable of convergence. The error signal e(t-1) is thus output as the corrected error signal $e_{cp}$(t -1), and the tap factor updating unit 6 adjusts the tap factors $K_0(t)$ to $K_m(t)$ based on this corrected error signal $e_{cp}$(t-1) according to the algorithm expressed by the foregoing equation (2a). This allows the corrected error signal $e_{cp}$(t-1) and the error signal e(t-1) to converge to near zero at a speed depending on the predetermined coefficient $\alpha$, so that the digital filter 2 can eliminate the multipath noise (multipath distortion).

Suppose, on the other hand, the case where the delay time of the multipath distortion is shorter than the total delay time, i.e., where multipath distortion possible for the digital filter 2 to eliminate is input. Here, the error signal Dce(t-1) exceeding the predetermined amplitude is settled after a lapse of the time determined by the time constant of the digital low-pass filter 5b, and is supplied to the amplitude control circuit 5c. Consequently, the amplitude control circuit 5c controls the attenuation or gain of the amplitude limiting circuit 5d, so that the amplitude limiting circuit 5d suppresses the amplitude of the input error signal e (t-1) and outputs the amplitude-suppressed signal as the corrected error signal $e_{cp}$(t-1).

Based on this suppressed corrected error signal $e_{cp}$(t=1), the tap factor updating unit 6 then adjusts the tap factors $K_0(t)$ to $K_m(t)$ according to the algorithm expressed by the foregoing equation (2a). Since the value of the coefficient $\alpha$ substantially decreases as much as the amount of the foregoing suppression, the product of the corrected error signal $e_{cp}$(t-1) and the coefficient $\alpha$ can suppress variations of the individual tap factors $K_0(t)$ to $K_m(t)$. This achieves the stabilization of the digital filter 2.

Figs. 3 and 4 show the characteristics of the multipath elimination filter according to this practical example described above. Fig. 3 shows the waveform of an input signal Xin(t) which is difficult to converge, the waveform of the desired signal Y(t-1) which is generated in response to the input signal Xin(t), and the waveforms of the error signal e (t-1) and the smoothened error signal Dce(t-1).

Fig. 4 shows the waveform of an input signal Xin(t) for situations where the delay time of the multipath distortion (noise) is shorter than the total delay time, the waveform of the desired signal Y(t) generated in response to the input signal Xin(t), and the waveform of the error signal e(t).

As is evident from the characteristic of Fig. 4, according to the present embodiment, the amplitude of the error signal e (t) will not approach zero over a long time because of multipath effects. This precludes unstable operation. In contrast, Fig. 3 shows that the error signal e(t-1) converges to near zero, and the digital filter 2 makes convergence. The digital filter 2 can thus generate the desired signal Y(t-1) which can eliminate multipath distortion appropriately for the sake of improved reception quality.

Incidentally, in the multipath elimination filter 1 described above, the tap factors $K_0(t)$ to $K_m(t)$ are adjusted while the signal generated by suppressing the amplitude of the error signal $e(t-1)$, i.e., the corrected error signal ecp $(t-1)$ is applied to the foregoing equation (2a) for stable operation. Nevertheless, the individual tap factors $K_0(t)$ to $K_m$ $(t)$ may be adjusted according to an algorithm of multiplying the tap factor $K_j(t)$ by a variable coefficient $\gamma$, as shown by the following equation (3). Such a configuration allows further stabilization of operation.

According to the multipath elimination filter 1 having such a configuration, when the foregoing corrected error signal $e_{cp}(t-1)$ exceeds a predetermined value, the processing system including the digital filter 2 shown in Fig. 2 operates to control the updating values of the individual tap factors $K_0(t)$ to $K_m(t)$ as well as make the individual tap factors $K_0(t)$ to $K_m(t)$ approach zero. Consequently, even if there is the possibility of unstable operation due to multipath effects, it is possible to achieve further stabilization of operation and generate the desired signal $Y(t-1)$ which can eliminate the multipath distortion appropriately for the sake of improved reception quality.

$$K_j(t) = \gamma \cdot K_j(t-1) - \alpha \cdot e_{cp}(t) \cdot \{X_j(t) \cdot Y(t) + X_j(t-1) \cdot Y(t-1)\} \qquad \text{[Eq. 3]}$$

where: j is the order of the tap factors, j = 0, 1, 2, 3, ... m;
$\alpha$ and $\gamma$ are predetermined constants, $\alpha > 0$ and $0 < \gamma < 1$;
t is a natural number indicating the point of time in units of delay time T; and
$e_{cp}(t)$ is the corrected error signal.

**Claims**

1. A multipath elimination filter (1) **characterized by** :

   a digital filter (2) for receiving a digitalized FM modulation signal or phase modulation signal as its input signal $(Xin(t))$, and eliminating multipath distortion from the input signal $(Xin(t))$ by adjusting tap factors $(K_m(t))$ for the input signal $(Xin(t))$;
   envelope detecting means (3) for detecting an envelope of the input signal $(Xin(t))$ to generate a reference signal $(Vth(t))$;
   errordetectingmeans (4) forgeneratinganerrorsignal $(e(t))$ by performing a differential operation on a desired signal $(Y(t))$ generated by the digital filter (2) and the reference signal $(Vth(t))$ ;
   error component limiting means (5) for monitoring the error signal $(e(t))$ for a direct-current component and controlling an amplitude of the error signal $(e (t) )$ to generate a corrected error signal $(e_{cp}(t))$; and
   tap factor updating means (6) for adjusting the tap factors $(K_m(t))$ based on the corrected error signal $(e_{cp}(t))$ so that the amplitude of the error signal $(e(t))$ approaches zero.

2. The multipath elimination filter (1) according to claim 1, wherein
   the tap factor updating means (6) adjusts the individual tap factors according to an algorithm expressed by

   $$K_j(t) = K_j(t-1) - \alpha \cdot e_{cp}(t) \cdot \{X_j(t) \cdot Y(t) + X_j(t-1) \cdot Y(t-1)\},$$

   where $X_j(t)$ and $X_j(t-1)$ are the input signal, $Y(t)$ and $Y(t-1)$ are the desired signal, $K_j(t)$ and $K_j(t-1)$ are the tap factors, $\alpha$ is a predetermined constant, t is a delay time determined based on a sampling frequency, j is the order of the tap factors, and $e_{cp}(t)$ is the corrected error signal.

3. The multipath elimination filter (1) according to claim 1 or 2, wherein
   the tap factor updating means (6) adjusts the individual tap factors according to an algorithm expressed by

   $$K_j(t) = \gamma \cdot K_j(t-1) - \alpha \cdot e_{cp}(t) \cdot \{X_j(t) \cdot Y(t) + X_j(t-1) \cdot Y(t-1)\},$$

   where $X_j(t)$ and $X_j(t-1)$ are the input signal, $Y(t)$ and $Y(t-1)$ are the desired signal, $K_j(t)$ and $K_j(t-1)$ are the tap factors, $\alpha$ is a predetermined constant, t is a delay time determined based on a sampling frequency, j is the order of the tap factors, $e_{cp}(t)$ is the corrected error signal, and $\gamma$ is any predetermined constant in a range of 0 and 1.

# FIG.1

## FIG.2

# FIG.3

$X_{in}(t)$

$Y(t-1)$

$e(t-1)$

PREDETERMINED AMPLITUDE

$Dce(t-1)$

# FIG.4

PRIOR ART

$X_{in}(t)$

$Y(t)$

$e(t)$

# *FIG.5*

## PRIOR ART